# DEMANDE DE BREVET EUROPEEN

(11) **EP 4 059 781 A1**
(43) Date de publication de la demande: **21.09.2022**
(21) Numéro de dépôt: 22162208.7
(22) Date de dépôt: 15.03.2022
(51) Int. Cl.: B60R 16/023, H05K 5/00, H02M 3/00

(54) **BOÎTIER POUR COMPOSANTS ÉLECTRIQUES D'UN VÉHICULE AUTOMOBILE**

(30) Priorité: 16.03.2021 FR 2102630
(71) Demandeur: Renault s.a.s, 92100 Boulogne Billancourt (FR)
(72) Inventeur: DIZIER, LAURE, 78640 VILLIERS-SAINT-FREDERIC (FR); MARREL, Sébastien, 78640 VILLIERS-SAINT-FREDERIC (FR)
(74) Mandataire: Renault Group

(57) **Abrégé**

Boîtier (1) pour composants électriques d'un véhicule automobile (100) constituant un support pour au moins deux ou au moins trois composants électriques, notamment au moins deux ou au moins trois composants parmi :
- un premier convertisseur électrique de tension 48V-12V (4),
- un deuxième convertisseur électrique de tension 48V-12V (5),
- un calculateur pour moteur (2),
- un calculateur pour grille chauffante (3),
- un module de sécurité de batterie 12V (7), et
- un bornier électrique (6),
le boîtier comprenant :
- des éléments (E4, E5, A3, A4, A5, A6, C2, C3, C4, C5, 81, 82, 83, 84, 85, 86, AB, BC, CD, DA, 131, 132, 133, 134) de fixation des composants électriques au boîtier, et
- des éléments (E1, E2, E3) de fixation du boîtier à une structure de fixation (110) d'un véhicule automobile.

## Description

L'invention concerne un boîtier pour composants électriques d'un véhicule automobile. L'invention porte aussi sur un pack électrique comprenant un tel boîtier. L'invention porte également sur un procédé de montage d'un tel pack électrique. L'invention porte encore sur un véhicule automobile équipé d'un tel pack électrique. L'invention porte également sur un procédé de montage d'un tel véhicule automobile.

La réduction de l'empreinte carbone des véhicules constitue un axe majeur de l'innovation technologique, notamment dans l'industrie automobile.

Certaines de ces innovations nécessitent l'ajout d'une batterie 48 Volts dans les véhicules thermiques, la batterie 48 Volts étant destinée à alimenter différents équipements électriques permettant de réduire les émissions de carbone. Notamment, la batterie 48 Volts permet dans certains véhicules d'alimenter une grille chauffante pour améliorer les performances du pot catalytique. En complément ou alternativement, la batterie 48 Volts peut également alimenter un petit moteur électrique, appelé aussi alterno-démarreur, destiné à épauler le moteur thermique sur des phases de conduite spécifiques, notamment des redémarrages du véhicule lors de la mise en œuvre de la fonction Stop and Start. Réciproquement, l'alterno-démarreur alimente à son tour la batterie 48 Volts pendant les phases de conduite.

L'ajout d'une batterie 48 Volts entraine l'ajout dans le compartiment moteur de divers composants associés à l'utilisation d'une telle batterie. L'implantation de nouveaux composants dans une structure de véhicule préexistante présente toutefois des contraintes de disposition spatiale de ces nouveaux éléments. Les contraintes concernent non seulement l'espace disponible pour loger ces composants, mais aussi les trajets des nouveaux tuyaux et câbles requis pour ces composants.

Le but de l'invention est de fournir un dispositif permettant de pallier les contraintes précédemment décrites. En particulier, l'invention permet de réaliser un dispositif qui soit simple et fiable et qui permette une installation compacte et un raccordement optimal de nouveaux composants électriques dans le compartiment moteur.

A cet effet, l'invention porte sur un boîtier pour composants électriques d'un véhicule automobile constituant un support pour au moins deux ou au moins trois composants électriques, notamment au moins deux ou au moins trois composants parmi :
- un premier convertisseur électrique de tension 48V-12V,
- un deuxième convertisseur électrique de tension 48V-12V,
- un calculateur pour moteur,
- un calculateur pour grille chauffante,
- un module de sécurité de batterie 12V, et
- un bornier électrique,
le boîtier comprenant en outre :
- des éléments de fixation des composants électriques au boîtier, et
- des éléments de fixation du boîtier à une structure de fixation d'un véhicule automobile.

Les dimensions du boîtier peuvent lui permettre de s'insérer dans un espace prévu pour une batterie électrique 12V de type L3 et/ou le boîtier peut être destiné à être implanté dans un compartiment moteur d'un véhicule automobile.

Le boîtier peut comprendre :
- une première partie comprenant cinq faces sensiblement planes constituant respectivement une base, de forme sensiblement rectangulaire, et quatre parois latérales fixées perpendiculairement à la base, et
- un couvercle s'emboitant sur la première partie, le couvercle présentant une face principale, notamment de forme sensiblement identique à la base, et,
- un logement fixé sur le dessus de la face principale du couvercle, le logement comprenant un socle et un couvercle.

Une première paroi latérale peut présenter une ouverture destinée à un raccordement des composants électriques à une connectique électrique et une deuxième paroi latérale peut présenter une ouverture destinée à un raccordement des composants électriques à un circuit de refroidissement.

Le boîtier peut comprendre des aménagements permettant de disposer les composants électriques au moins sensiblement parallèlement les uns aux autres.

Les aménagements peuvent être agencés de sorte que les composants soient disposés :
- horizontalement, ou
- selon un angle aigu supérieur ou égal à 8° par rapport à l'horizontale, ou
- verticalement ou sensiblement verticalement.

L'invention porte également sur un pack électrique comprenant un boîtier pour composants électriques selon l'invention et au moins deux composants ou au moins trois parmi :
- un premier convertisseur électrique de tension 48 Volts-12 Volts,
- un deuxième convertisseur électrique de tension 48 Volts-12 Volts,
- un calculateur pour moteur,
- un calculateur pour grille chauffante,
- un élément de sécurité de batterie 12 Volts, et
- un bornier électrique.

L'invention porte en outre sur un procédé d'assemblage d'un pack électrique selon l'invention, comprenant les étapes suivantes :
- au moins une première étape de montage d'un premier composant électrique dans le boîtier, et
- au moins une deuxième étape de montage d'un deuxième composant électrique dans le boîtier,
par exemple :
- une première étape de pose du calculateur pour moteur sur la base du boîtier,
- une deuxième étape de pose d'un premier convertisseur au-dessus du calculateur pour moteur,
- une troisième étape de pose d'une plaque au-dessus du premier convertisseur,
- une quatrième étape de pose du deuxième convertisseur au-dessus de la plaque,
- une cinquième étape d'emboîtement du couvercle du boîtier sur la première partie du boîtier,
- une sixième étape de pose du bornier électrique dans le socle du logement du boîtier,
- une septième étape d'emboîtement du couvercle du logement sur le socle du logement,
- une huitième étape de pose d'un calculateur pour grille chauffante sur le couvercle du logement, et
- une neuvième étape de fixation d'un élément de sécurité sur la plaque, les étapes de pose d'un composant comprenant au moins un assemblage du composant au boîtier.

L'invention porte en outre sur un véhicule automobile comprenant, notamment comprenant dans un compartiment moteur, un pack électrique selon l'invention.

L'invention porte par ailleurs sur un procédé d'assemblage d'un véhicule automobile, notamment d'un véhicule automobile selon l'invention, le véhicule comprenant au moins un conduit de refroidissement hydraulique, un conduit aéraulique, des câblages électriques et une structure de fixation, le procédé comprenant :
- une première étape de fixation d'un boîtier à la structure de fixation,
- une deuxième étape de mise en œuvre du procédé d'assemblage selon l'invention,
- une troisième étape de connexion de l'au moins un conduit de refroidissement hydraulique au pack électrique, notamment à des convertisseurs électriques,
- une quatrième étape de fixation du conduit aéraulique au pack électrique,
- une cinquième étape de raccordement de l'ensemble des composants électriques au câblage électrique.

Le dessin annexé représente, à titre d'exemple, un mode de réalisation d'un boîtier pour composants électriques selon l'invention.
[Fig. 1] La figure 1 représente schématiquement un véhicule automobile équipé d'un boîtier pour composants électriques selon un mode de réalisation.
[Fig. 2] La figure 2 est une vue en perspective d'une première partie d'un boîtier pour composants électriques selon un mode de réalisation de l'invention.
[Fig. 3] La figure 3 est une vue en coupe de la première partie d'un boîtier pour composants électriques selon le mode de réalisation de l'invention.
[Fig. 4] La figure 4 est une vue en perspective d'une plaque d'un boîtier pour composants électriques selon le mode de réalisation de l'invention.
[Fig. 5] La figure 5 est une vue en perspective d'un couvercle d'un boîtier pour composants électriques selon le mode de réalisation de l'invention.
[Fig. 6] La figure 6 est une vue en perspective d'un couvercle pour le logement d'un boîtier pour composants électriques selon le mode de réalisation de l'invention.
[Fig. 7] La figure 7 est un ordinogramme d'un procédé d'assemblage d'un pack électrique selon un mode d'exécution.
[Fig. 8] La figure 8 illustre la première étape du procédé d'assemblage d'un pack électrique selon le mode d'exécution.
[Fig. 9] La figure 9 illustre la deuxième étape du procédé d'assemblage d'un pack électrique selon le mode d'exécution.
[Fig. 10] La figure 10 illustre la troisième étape du procédé d'assemblage d'un pack électrique selon le mode d'exécution.
[Fig. 11] La figure 11 illustre la quatrième étape du procédé d'assemblage d'un pack électrique selon le mode d'exécution.
[Fig. 12] La figure 12 illustre la cinquième étape du procédé d'assemblage d'un pack électrique selon le mode d'exécution.
[Fig. 13] La figure 13 illustre la sixième et la septième étape du procédé d'assemblage d'un pack électrique selon le mode d'exécution.
[Fig. 14] La figure 14 illustre la huitième étape du procédé d'assemblage d'un pack électrique selon le mode d'exécution.
[Fig. 15] La figure 15 illustre la neuvième étape du procédé d'assemblage d'un pack électrique selon le mode d'exécution.
[Fig. 16] La figure 16 est un ordinogramme d'un procédé d'assemblage d'un véhicule selon un mode d'exécution.
[Fig. 17] La figure 17 est une première vue en perspective des raccordements d'un véhicule selon le mode de réalisation de l'invention.
[Fig. 18] La figure 18 est une deuxième vue en perspective des raccordements d'un véhicule selon le mode de réalisation de l'invention.
[Fig. 19] La figure 19 est une troisième vue en perspective des raccordements d'un véhicule selon le mode de réalisation de l'invention.

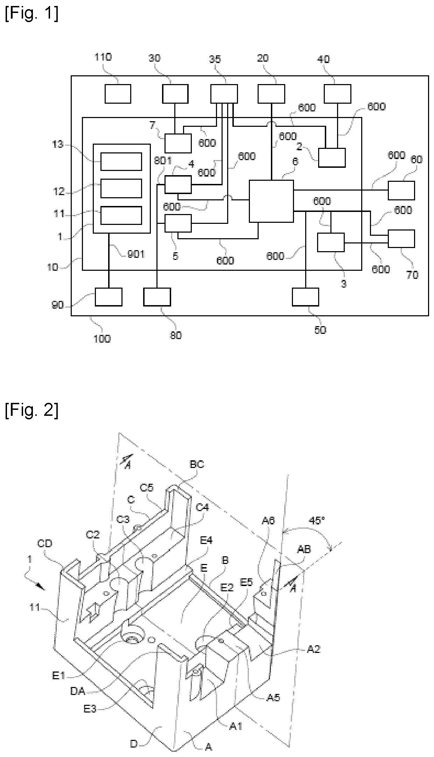

Un mode de réalisation d'un véhicule automobile 100 est décrit ci-après en référence à la figure 1. Le véhicule automobile 100 est un véhicule automobile de n'importe quel type, notamment un véhicule de tourisme ou un véhicule utilitaire.

Le véhicule automobile 100 est équipé d'un bloc moteur comprenant un moteur thermique 40. Le moteur thermique est de tout type, notamment à essence ou diesel. Dans un mode de réalisation, le bloc moteur pourrait comprendre en outre un moteur électrique 50, notamment un alterno-démarreur 50 pour permettre la mise en œuvre d'une micro-hybridation.

Associé au moteur thermique 40, le véhicule automobile 100 comprend de plus un premier composant électrique ou calculateur, dit calculateur pour moteur 2, qui contrôle le fonctionnement du moteur thermique.

Le véhicule automobile 100 comprend également une ligne d'échappement équipée d'une grille chauffante 70 permettant d'optimiser l'efficacité du traitement postcombustion mis en œuvre dans le véhicule.

Associé à la grille chauffante 70, le véhicule automobile 100 comprend également un deuxième composant électrique ou calculateur, dit calculateur pour grille chauffante 3, qui contrôle le fonctionnement de la grille chauffante.

Le véhicule automobile 100 est équipé d'une première batterie 20 fournissant une tension de 48 Volts destinée notamment à l'alimentation électrique de la grille chauffante 70, et éventuellement d'un moteur électrique 50.

La batterie 48 Volts pouvant générer un surplus de courant, avantageusement le véhicule automobile 100 peut également être équipé d'un troisième composant électrique permettant de convertir une tension de 48 Volts en tension de 12 Volts. Le troisième composant électrique est également nommé premier convertisseur 4.

Le véhicule automobile 100 est également équipé d'une deuxième batterie 30 fournissant une tension de 12 Volts destinée notamment à l'alimentation électrique des équipements électriques et électroniques du véhicule automobile 100. La deuxième batterie 30 est reliée à un quatrième composant électrique, dit module de sécurité 7, contenant des fusibles. Ces fusibles sécurisent les circuits d'alimentation qui relient la deuxième batterie 30 aux équipements électriques et électroniques qu'elle alimente.

Le véhicule automobile 100, en particulier lorsqu'il s'agit d'un véhicule utilitaire, peut comprendre un ou plusieurs équipements additionnels 60, spécifiques au domaine d'utilisation du véhicule utilitaire. Ces équipements additionnels sont généralement alimentés par une tension de 12 Volts. Par exemple, le véhicule 100 peut comprendre des réfrigérateurs ou autres équipements consommant une quantité importante de tension de 12 Volts.

Avantageusement, le véhicule automobile 100 peut comprendre un cinquième composant électrique, dit deuxième convertisseur 5, permettant de fournir une quantité importante de tension de 12 Volts, par transformation d'un surplus important de tension de 48 Volts.

Le véhicule automobile 100 peut être équipé d'un moyen de refroidissement hydraulique 80 relié à au moins un conduit de refroidissement hydraulique 801.

Le véhicule automobile 100 peut être de plus équipé d'un moyen de refroidissement aéraulique 90 relié à un conduit aéraulique 901.

Les premier, deuxième, troisième, quatrième et cinquième composants électriques 2, 3, 4, 5, 7 sont agencés dans un boîtier 1 selon l'invention.

Afin d'organiser la distribution de courant électrique dans les composants électriques du boîtier, un sixième composant électrique, ou bornier 6, est avantageusement disposé dans le boîtier 1.

L'agencement des six composants électriques 2, 3, 4, 5, 6, 7 dans le boîtier 1 constitue un pack électrique 10. Un des rôles du pack électrique, et plus particulièrement du boîtier 1, est d'optimiser l'espace nécessaire à l'implantation des six composants électriques 2, 3, 4, 5, 6, 7.

Avantageusement, le pack électrique 10 est destiné à être implanté dans un compartiment moteur d'un véhicule automobile. Dans le mode de réalisation préférentiel décrit ci-après, les dimensions réduites du pack électrique 10, et plus particulièrement du boîtier 1, lui permettent de s'insérer dans un espace équivalent à celui traditionnellement prévu pour loger une batterie électrique 12V de type L3 notamment dans le compartiment moteur. Autrement dit, dans ce mode de réalisation, le volume du pack électrique 10 est tel qu'il peut s'insérer dans un parallélépipède rectangle défini par les dimensions suivantes : 261,7mm x 282,6 mm x 350mm.

Le véhicule automobile 100 comprend en outre une structure de fixation 110 apte à recevoir le pack électrique 10, notamment apte à être fixée au boîtier 1. La structure de fixation 110 peut être par exemple une équerre initialement prévue pour un bac de batterie 12 Volts. La structure de fixation 110 pourrait également être le longeron du véhicule 100. Dans un mode de réalisation préférentiel, la structure 110 comprend une surface sensiblement horizontale destinée à être en contact avec la surface inférieure du boîtier 1.

Les différents composants électriques du boîtier sont alimentés, par l'intermédiaire de raccordements 600, soit en courant continu de 48 Volts, soit en courant continu de 12 Volts.

En ce qui concerne l'alimentation en courant continu de 12 Volts, on distingue deux circuits d'alimentation :
- un premier circuit d'alimentation en 12 Volts est relié aux convertisseurs 4, 5 via le bornier 6 du pack électrique 10, le courant en 12 Volts étant généré par les convertisseurs 4, 5,
- et un deuxième circuit d'alimentation en 12 Volts est relié à la batterie 12 Volts via un boîtier d'interconnexion 35 dit « boitier d'interconnexion moteur », externe au pack électrique 10.

Le premier circuit concerne exclusivement l'alimentation des équipements additionnels 60. Il utilise le courant en 12 Volts généré par les convertisseurs 4, 5 pour alimenter les équipements additionnels 60 via le bornier 6.

Par l'intermédiaire du boîtier d'interconnexion 35, le deuxième circuit raccorde la batterie 12 Volts 30 et l'élément de sécurité 7 aux éléments du véhicule 100 - autres que les équipements additionnels 60- qui sont alimentés en 12 Volts. Notamment, le calculateur moteur 2 est relié, via un raccordement 600, au boîtier d'interconnexion moteur 35.

De plus, le deuxième circuit comprend avantageusement des raccordements 600 reliant les convertisseurs 4, 5 au boîtier d'interconnexion 35, notamment pour recharger la batterie 30.

Concernant l'alimentation en 48 Volts, dans un mode de réalisation préférentiel, le bornier 6 constitue l'unique point d'entrée du courant continu de 48 Volts dans le pack électrique 10. A cet effet, le bornier 6 est alimenté par un signal continu de 48 Volts par l'intermédiaire d'un raccordement 600 à la batterie 20.

Dans ce mode de réalisation, le bornier 6 constitue également l'unique point de sortie du courant continu de 48 Volts vers les équipements extérieurs au pack électrique 10 utilisant un signal continu de 48 Volts. Autrement dit, les circuits 600 d'alimentation du moteur électrique 50, du calculateur pour grille chauffante 3 et de la grille chauffante 70 sont reliés au bornier 6.

De plus, en interne au pack électrique 10, d'autres circuits 600 relient le bornier 6 aux convertisseurs 4, 5 pour leur alimentation par un signal continu de 48 Volts.

Une mode de réalisation du boîtier 1 est décrit ci-après en référence aux figures 2 à 5.

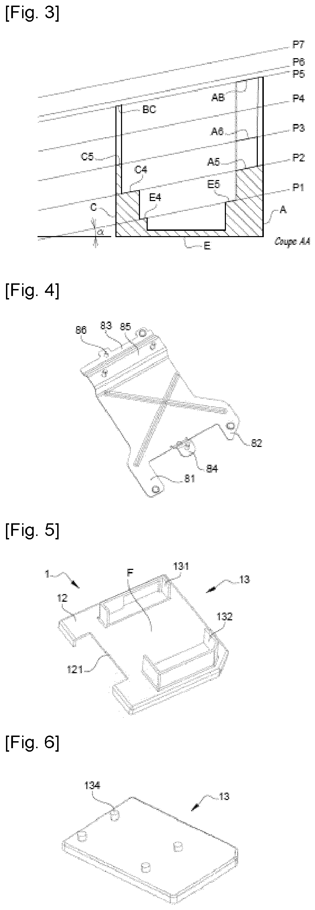

Dans le mode de réalisation décrit, le boîtier 1 comprend une première partie 11, plus particulièrement représentée dans les figures 2 et 3, présentant cinq faces A, B, C, D, E sensiblement planes constituant respectivement une base E, de forme sensiblement rectangulaire, et quatre parois latérales A, B, C, D fixées perpendiculairement à la base E.

Dans un mode de réalisation préférentiel, la base E du boîtier présente une longueur d'environ 283 mm (correspondant à la largeur des faces B et D, la largeur des faces B et D pouvant toutefois varier selon la hauteur) et une largeur d'environ 262 mm (correspondant à la largeur des faces A et C, la largeur des faces A et C pouvant toutefois varier selon la hauteur).

Dans le mode de réalisation présenté, les faces B et D sont en forme de trapèze rectangle, leur côté supérieur étant incliné par rapport à un plan contenant la base E. Les hauteurs des faces A, B, C et D sont préférentiellement comprises entre 220 mm et 260 mm.

Optionnellement le boîtier 1 comprend également un chanfrein à 45 degrés disposé sur l'angle formé par les deux parois latérales A, B contiguës.

Les parois latérales A, B, C, D présentent des ouvertures ou échancrures principales aux travers desquelles peuvent notamment s'étendre au moins un raccordement électrique, hydraulique ou aéraulique.

La paroi A présente notamment deux encoches A1, A2 et une ouverture permettant de raccorder l'au moins un conduit de refroidissement hydraulique 801 aux premier et deuxième convertisseurs 4, 5. Dans un mode de réalisation, les encoches A1, A2 présentent approximativement chacune une hauteur de 42 mm ainsi qu'une largeur de 52 mm pour A1 et de 47 mm pour A2.

Optionnellement, la paroi A présente également une ouverture (non représentée par les figures) destinée à un raccordement à un conduit aéraulique 901, ce raccordement s'effectuant directement sur le boîtier 1.

En complément ou alternativement, la paroi B présente également une ouverture qui s'étend sur une grande partie de sa hauteur afin de fournir une ouverture pour le raccordement du calculateur moteur 2. Notamment l'ouverture de la paroi B peut s'étendre sur environ 232 mm de hauteur et entre 170 et 190 mm de largeur.

En complément ou alternativement, la paroi C présente également une ouverture dans sa partie supérieure pour permettre la fixation de l'élément de sécurité 7. Notamment l'ouverture de la paroi C peut s'étendre sur environ 58 mm de hauteur et 205 mm de largeur.

En complément ou alternativement, la paroi D présente également une ouverture dans sa partie supérieure pour permettre le raccordement des convertisseurs 4, 5. Notamment l'ouverture de la paroi D peut s'étendre sur environ 157 à 181 mm de hauteur et 185 mm de largeur.

Ainsi, dans le mode de réalisation présenté, chacune des parois A, B, C, et D se résume, dans sa partie supérieure, à deux montants étroits encadrant une large ouverture. Lesdits montants étroits de deux faces contiguës forment, deux à deux, des équerres BC, CD, DA. L'angle formé par les parois A et B étant chanfreiné, les parois A et B présentent dans leur partie supérieure un montant commun AB correspondant au chanfrein. En remarque, le chanfrein a pour fonction d'optimiser l'encombrement du boîtier 1, notamment relativement à l'environnement dans lequel le boîtier est destiné à s'insérer. Dans d'autres modes de réalisation, ce chanfrein pourrait ne pas être nécessaire.

Le boîtier 1 comprend :
- des éléments de fixation des composants électriques 2, 3, 4, 5, 6, 7 au boîtier 1, et
- des éléments de fixation du boîtier 1 à la structure de fixation 110 du véhicule automobile 100.

Les éléments de fixation sont décrits ci-après. Dans la suite du document, les termes « éléments de fixation », « surface d'appui » ou « surface de fixation » sont indifféremment utilisés pour désigner un élément de fixation. Un élément de fixation peut être, par exemple, une surface, telle une surface d'appui, ou un trou dans une surface, au travers duquel s'étend un moyen de fixation.

La base E du boîtier est globalement continue sur toute sa surface, c'est-à-dire approximativement pleine, en ce sens qu'il n'y a pas d'ouverture ou échancrure de passage d'un raccordement comme cela est le cas d'au moins une des parois latérales. Elle présente trois éléments de fixation, notamment trois ouvertures E1, E2, E3 pour le passage de vis de fixation du premier élément du boiter à la structure 110 de fixation du véhicule 100.

En outre, la base E ainsi que les parois latérales A et C de la première partie 11 fournissent des éléments de fixation, notamment des surfaces d'appui pour le positionnement et la fixation du calculateur pour moteur 2 et du premier convertisseur de courant 4.

A cet effet, la base E comprend également deux épaulements E4, E5 dont la surface est contenue dans un premier plan d'appui P1. Le plan d'appui P1 est incliné d'un angle α par rapport à la surface d'appui de la base E. Les épaulements E4, E5 fourniront des éléments de fixation pour le montage du calculateur pour moteur 2.

Les parois latérales A et C, disposées en vis-à-vis l'une de l'autre, fournissent respectivement des éléments de fixation comprenant des surfaces d'appui A5, C4 qui sont contenues dans un deuxième plan d'appui P2, parallèle à P1. Les surfaces d'appui A5, C4 serviront d'appui et de support de fixation pour le premier convertisseur 4.

Les parois latérales A et C fournissent également des éléments de fixation comprenant des surfaces d'appui pour la fixation d'une plaque 8 disposée entre le premier convertisseur 4 et le deuxième convertisseur 5. La face latérale A fournit deux surfaces de fixation, A6 et A7, et la face latérale C fournit un élément de fixation C5.

Grâce à ces éléments de fixation, la plaque 8 est disposée selon un troisième plan de fixation P3 parallèle aux deux premiers plans de fixation, P1, P2.

La plaque 8 est plus spécifiquement décrite par la figure 4. La surface de la plaque 8 est répartie selon principalement deux plans, un plan inférieur et un plan supérieur. Le plan inférieur comprend les premier, deuxième et troisième éléments 81, 82, et 83 de la plaque 8 qui sont des surfaces destinées à être fixées aux éléments de fixation A6, A7, C5. Autrement dit, après fixation, le plan inférieur de la plaque 8 sera disposé dans le troisième plan P3.

Par ailleurs, dans son plan supérieur, la plaque 8 fournit des éléments de fixation 84, 85 destinés à la fixation du deuxième convertisseur 5 dans un plan de fixation P4 parallèle aux autres plans de fixation P1, P2, et P3.

Dans un mode de réalisation, la plaque 8 fournit en outre un élément de fixation 86 destiné à fixer l'élément de sécurité 7 de la batterie 12 Volts.

Outre la première partie 11, le boîtier 1 selon l'invention comprend un couvercle 12 (représenté par la figure 5) s'emboitant sur la première partie 11, le couvercle présentant une face principale F, notamment de forme sensiblement identique à la base E.

Le couvercle 12 est destiné à s'emboîter sur les extrémités supérieures des montants AB, BC, CD, DA précédemment décrits. Avantageusement, les extrémités supérieures des montants AB, BC, CD, DA ont été dimensionnées de sorte à se situer dans un même plan de fixation P5, parallèle aux autres plans de fixation. Ainsi le couvercle 12 est également incliné d'un angle α par rapport à la surface d'appui de la base E. Le dessus de la face principale F du couvercle se situe ainsi dans un plan de fixation P6 parallèle aux autres plans de fixation, la distance entre les plans P5 et P6 correspondant à l'épaisseur du couvercle.

Avantageusement, le couvercle 12 comprend un évidement 121 de forme rectangulaire, disposé sur le bord latéral destiné à venir d'emboîter sur la face latérale D de la première partie 11 du boîtier.

Un logement 13 est fixé sur le dessus de la face principale F du couvercle 12, le logement comprenant un socle en deux parties 131, 132 et un couvercle 133 s'emboîtant sur les deux parties 131, 132 du socle. Les deux parties 131, 132 du socle sont en forme de crochets ou créneaux placés en vis-à-vis l'un de l'autre, de sorte à délimiter un cadre. Un composant électronique, notamment le bornier 6, peut être déposé sur le couvercle 12 à l'intérieur de ce cadre. Avantageusement les dimensions du cadre sont adaptées aux dimensions du bornier 6 de sorte à limiter le jeu entre le bornier et le cadre. Le couvercle 133, représenté par la figure 6, peut être emboîté sur le cadre afin de fermer l'espace défini par le cadre. L'ensemble du socle 131, 132 et du couvercle 133 constitue un élément de fixation d'un composant électrique dans le boîtier 1, notamment un élément de fixation du bornier 6.

La hauteur des deux parties 131, 132 du socle est définie de sorte à disposer le couvercle du logement 133 selon un plan P7 parallèle à P6. Le couvercle 133 comprend en outre un élément de fixation 134 sur sa surface supérieure, l'élément de fixation étant destiné au calculateur 3 de la grille chauffante. Dans un mode de réalisation l'élément de fixation comprend quatre vis ou quatre pions de fixation destinés à s'insérer dans des œillets du calculateur 3.

Ainsi, dans le mode de réalisation décrit, le boîtier 1, associé à la plaque 8, fournit des éléments E4, E5, A3, A4, A5, A6, C2, C3, C4, C5, 81, 82, 83, 84, 85, 86, AB, BC, CD, DA, 131, 132, 133, 134 de fixation des composants électriques 2, 3, 4, 5, 6, 7 au boîtier 1. Par ailleurs le boîtier 1 fournit des éléments E1, E2, E3 de fixation à la structure de fixation 110 du véhicule automobile 100.

Ainsi dans le mode de réalisation préférentiel précédemment décrit, le boîtier et les éléments de fixation fournis par le boîtier sont définis pour disposer les composants électriques 2, 3, 4, 5, 6 les uns au-dessus des autres, dans des plans P1, P2, P4, P5, P6, P7 sensiblement parallèles entre eux et formant chacun un angle α avec la surface inférieure du boîtier 1. La surface inférieure du boîtier 1 est elle-même disposée selon un plan sensiblement horizontal par l'intermédiaire de la structure de fixation 110 du véhicule automobile 100. De ce fait, les composants électriques 2, 3, 4, 5, 6 sont inclinés par rapport à un plan horizontal, notamment d'un angle sensiblement égal à a. Selon la règlementation concernant les équipements électriques d'un véhicule automobile, pour éviter la stagnation de l'eau à la surface des équipements électriques, l'angle α doit être supérieur ou égal à 8 degrés.

Dans un mode de réalisation alternatif, les composants électriques pourraient être disposés selon une autre orientation, par exemple verticale ou sensiblement verticale. Un tel mode de réalisation pourrait être avantageux dans des situations ou l'encombrement du boîtier serait contraint en hauteur. En particulier, un tel mode de réalisation pourrait être préférable lorsque l'espace disponible pour installer le pack électrique dans le véhicule 100 est d'une hauteur inférieure à ses autres dimensions, notamment sa largeur et/ou sa profondeur.

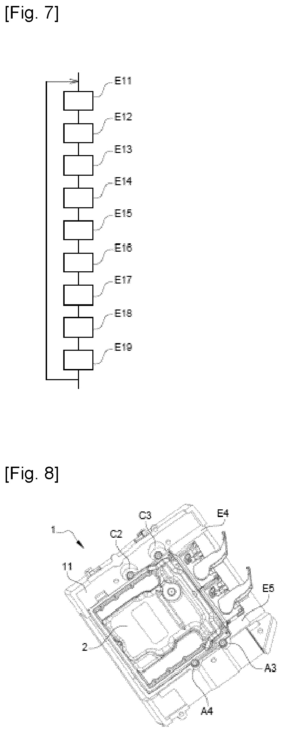

Un mode d'exécution d'un procédé d'assemblage d'un pack électrique 10 selon l'invention est décrit ci-après en référence à la figure 7. Le mode d'exécution décrit correspond au mode de réalisation préférentiel du pack électrique, c'est-à-dire au mode de réalisation où les composants électriques sont disposés les uns au-dessus des autres.

Le procédé d'assemblage d'un pack électrique comprend neuf étapes, E11 à E19, qui s'exécutent successivement.

Une première étape E11 de montage du pack 10 est illustrée par la figure 8. La première étape E11 est une étape de pose du calculateur pour moteur 2 sur la base E du boîtier 1. Le calculateur pour moteur 2 est disposé en appui sur les éléments de fixation E4, E5, ces éléments de fixation (plus spécifiquement visibles dans les figures 2, 3 et 8) étant réalisés par deux épaulements de la base E du boîtier 1. Le calculateur pour moteur 2 est ensuite fixé par des vis aux éléments de fixation E4, E5, par l'intermédiaire d'oreilles de fixation présentes sur le calculateur 2. Des évidements A3, A4, C2, C3 sont réalisés sur les faces latérales A et C pour fournir un passage aux oreilles de fixation du calculateur pour moteur 2. Le calculateur pour moteur 2 est disposé de sorte à orienter sa face dite connectique vers la face B du premier élément 11 du boîtier 1. La face connectique du calculateur 2 présente des ailettes de verrouillage mécanique du calculateur 2 au circuit électrique associé.

Avantageusement la face B est largement ouverte pour pouvoir effectuer ce verrouillage mécanique après la mise en place du calculateur dans le boîtier 1.

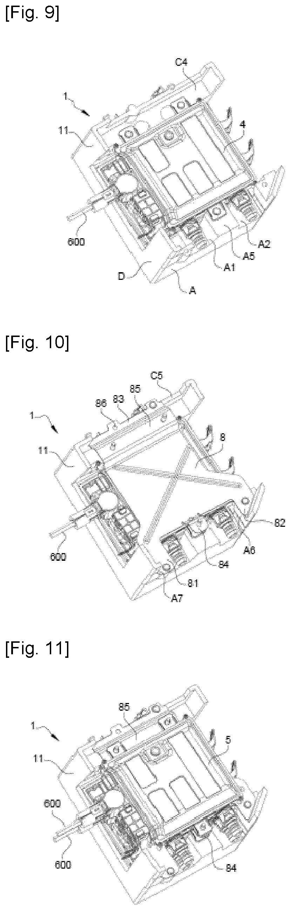

Une deuxième étape E12 de montage est illustrée par la figure 9. La deuxième étape E12 est une étape de pose du premier convertisseur 4 au-dessus du calculateur pour moteur 2. Le premier convertisseur 4 est disposé en appui sur les éléments de fixation A5 et C4 fournis respectivement par les faces latérales A et C. Le premier convertisseur 4 comprend trois oreilles de fixation pour sa fixation par des vis aux éléments de fixation A5 et C4. Dans un mode de réalisation alternatif, le premier convertisseur 4 pourrait comprendre un nombre de fixations différent ; dans ce cas, le boîtier 1 serait alors adapté pour fournir les éléments de fixations adéquats.

Par ailleurs, sur première face latérale, le premier convertisseur 4 présente des embouts de raccordement destinés à un raccordement à un conduit hydraulique 801. Les embouts de raccordement du premier convertisseur 4 sont avantageusement disposés dans des ouvertures A1, A2 réalisées sur la face latérale A.

En outre, sur une deuxième face latérale, le premier convertisseur 4 présente une prise de raccordement électrique destinée à un raccordement 600 du premier convertisseur 4 au bornier 6. La prise de raccordement du premier convertisseur 4 est avantageusement disposée face à une large ouverture réalisée sur la face latérale D.

Une troisième étape E13 de montage est illustrée dans la figure 10. La troisième étape E13 est une étape de pose de la plaque 8 au-dessus du premier convertisseur 4. Dans cette étape, la plaque de fixation 8 est disposée en appui sur les éléments de fixation A6, A7 et C5 fournis respectivement par les faces latérales A et C. Une fixation par vis est réalisée entre les premier, deuxième et troisième éléments 81, 82, 83 de la plaque 8 et les éléments de fixation A6, A7 et C5 des faces latérales A et C du boîtier 1.

Une quatrième étape E14 de montage est illustrée dans la figure 11. La quatrième étape E14 est une étape de pose du deuxième convertisseur 5 au-dessus de la plaque 8. Le deuxième convertisseur 5 est disposé en appui sur les éléments de fixation 84 et 85 fournis par le plan supérieur de la plaque 8. Le deuxième convertisseur 5 comprend trois oreilles de fixation pour sa fixation par des vis avantageusement disposées sur les éléments de fixation 84 et 85. Ainsi, le premier et le deuxième convertisseur 4, 5 sont disposés respectivement dans les plans P3 et P5, et séparés l'un de l'autre par la plaque 8. Notamment, du fait de sa géométrie, la plaque 8 préserve un espace libre entre les plans P3 et P5, cet espace libre permettant une meilleure aération et un meilleur refroidissement des convertisseurs 4, 5.

Par ailleurs, sur première face latérale, le deuxième convertisseur 5 présente des embouts de raccordement destinés à un raccordement à un conduit hydraulique 801. Les embouts de raccordement du deuxième convertisseur 5 sont avantageusement disposés dans une large ouverture réalisée sur la face latérale A.

En outre, sur une deuxième face latérale, le deuxième convertisseur 5 présente une prise de raccordement électrique destinée à un raccordement 600 du deuxième convertisseur 5 au bornier 6. La prise de raccordement du deuxième convertisseur 5 est avantageusement disposée face à la large ouverture réalisée sur la face latérale D.

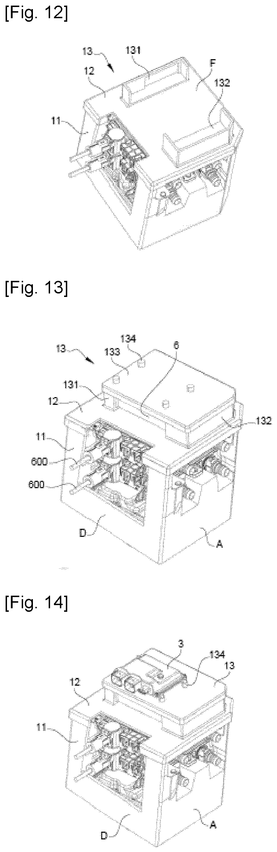

Une cinquième étape E15 de montage est illustrée par la figure 12. La cinquième étape E15 est une étape d'emboîtement du couvercle 12 du boîtier 1 sur la première partie 11 du boîtier 1. Le couvercle 12 du boitier est disposé en appui sur la partie supérieure des montants AB, BC, CD, DA de la première partie du boîtier 1. Le couvercle 12 peut être fixé par clipage et/ou maintenu par des vis sur la première partie 11 du boîtier. L'évidement 121 du couvercle est avantageusement disposé au-dessus de la face latérale D du boîtier, de sorte à faciliter le passage du raccordement électrique 600 du deuxième convertisseur 5.

Une sixième étape E16 et une septième étape E17 de montage sont illustrées par la figure 13. La sixième étape E16 est une étape de pose du bornier électrique 6 dans le socle 131, 132 du logement 13 disposé sur le couvercle 12 du boîtier.

Avantageusement, la face latérale du bornier 6 qui est orientée du côté de la face latérale D du boîtier fournit des raccordements pour les éléments reliés au circuit en 48 Volts, notamment pour la batterie 48 Volts 20, les convertisseurs 4, 5, le moteur électrique 50, le calculateur pour grille chauffante 2 et la grille chauffante 70. En complément ou alternativement, elle fournit également des raccordements pour les équipements additionnels 60 alimentés en 12 Volts à partir du courant fourni par les convertisseurs 4, 5.

La septième étape E17 est une étape d'emboîtement du couvercle 133 du logement 13 sur le socle 131, 132 du logement 13. Le couvercle 133 du logement 13 est ainsi disposé au-dessus du cadre formé par le socle 131, 132, pour la fixation du bornier 6 dans le logement 13. Le couvercle 133 peut être fixé au socle 131, 132 par des vis.

Une huitième étape E18 de montage est illustrée par la figure 14. La huitième étape E18 est une étape de pose d'un calculateur pour grille chauffante 3 sur le couvercle 133 du logement 13. Dans le mode de réalisation représenté dans la figure 12, le calculateur pour grille chauffante est doté sur ses bords latéraux de quatre emplacements pour vis. L'élément de fixation 134 du couvercle 133 quatre plots avantageusement disposés en vis-à-vis des logements pour vis du calculateur. Le calculateur 3 est ainsi fixé par des vis au couvercle 133. Avantageusement, la connectique du calculateur 3 est orientée vers la face latérale D du boîtier.

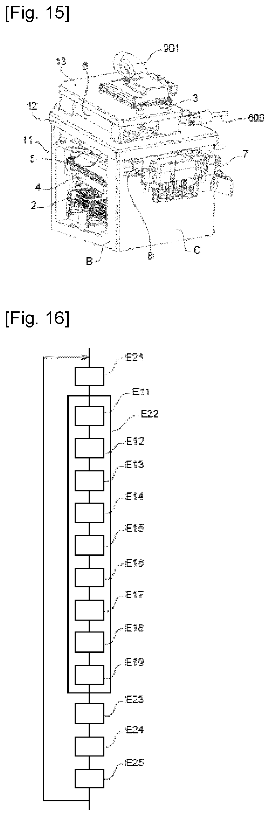

Une neuvième étape E19 de montage est illustrée dans la figure 15. La neuvième étape E19 est une étape de fixation de l'élément de sécurité 7 à la plaque 8, notamment par l'intermédiaire de l'élément de fixation 86. La liaison entre l'élément de sécurité 7 et l'élément de fixation 86 est réalisé par une vis et un écrou. Dans ce mode de réalisation, l'élément de sécurité 7 est disposé le long de la face latérale C du boîtier. En remarque, lorsque le montage s'effectue après la fixation du boîtier 1 dans le véhicule 100, l'étape de montage de l'élément de sécurité s'effectue préférentiellement après le montage des deux convertisseurs 4, 5, c'est-à-dire entre les étapes E14 et E15.

Dans un mode d'exécution alternatif, les étapes E16, E17 et E18 de montage des composants électriques 6 et 3 sur le couvercle du boîtier pourraient être exécutées avant l'étape E15 de montage du couvercle 12 sur la première partie 11 du boîtier 1.

Un mode d'exécution d'un procédé d'assemblage d'un véhicule selon l'invention est décrit ci-après en référence à la figure 16.

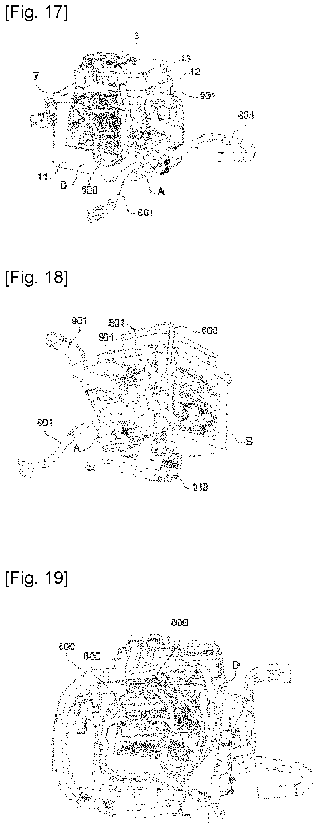

L'assemblage du véhicule 100 débute préférentiellement par une première étape E21 de fixation de la première partie 11 du boîtier à la structure de fixation 110 du véhicule 100. Pour cela, des vis peuvent par exemple être insérées dans les éléments de fixation E1, E2, E3 de la base E du boîtier (ces éléments de fixation étant plus spécifiquement représentés dans la figure 2). Les vis sont ensuite fixées à la structure de fixation 110 par des écrous (un mode de réalisation de la structure de fixation 110 étant illustré par la figure 18).

Le montage du boîtier 1 dans le véhicule automobile est réalisé de sorte à orienter la face latérale C du boîtier, destinée à recevoir l'élément de sécurité 7, vers le tablier du véhicule, c'est-à-dire vers l'extrémité arrière du véhicule. Avantageusement, le montage du boitier 1 permet de préserver un espace libre autour de la face latérale C, afin de préserver un espace libre autour de l'élément de sécurité 7 lorsqu'il sera assemblé au boitier, de sorte à permettre le raccordement d'une pince sur un câble de la batterie 12 Volts (la batterie 12 Volts étant elle-même difficilement accessible à l'usager puisque située sous la caisse du véhicule).

On enchaine sur une étape E22 d'assemblage ou de montage d'un pack électrique 10 dans le boîtier 1. L'étape E22 comprend les sous-étapes E11 à E19 précédemment décrites.

A l'issue de l'étape E22, les composants électriques 2, 3, 4, 5, 6, 7 ont été disposés de sorte à répartir spatialement leur connectique selon la nature des raccordements auxquels ils sont destinés. Notamment,
- les connectiques des composants électriques 2, 3, 4, 5, 6, 7 relatives à une alimentation en tension de 48 Volts ou de 12 Volts sont préférentiellement orientées vers la face latérale D du boîtier,
- les connectiques relatives au refroidissement des composants électriques, notamment au refroidissement des premier et deuxième convertisseurs 4, 5 sont orientées vers la face latérale A du boîtier pour un raccordement à l'au moins un conduit de refroidissement hydraulique 801. La face latérale A comprend avantageusement une ouverture pour la connexion à un conduit aéraulique 901.

De plus, suite à l'étape E21, la face latérale A du boîtier est orientée vers l'avant du véhicule, cette disposition permettant d'obtenir un refroidissement maximal de l'ensemble des composants électriques du boîtier.

La face latérale D, donnant accès à l'ensemble des connectiques des composants électriques du boîtier, est orientée vers le bloc moteur. Cette disposition simplifie ainsi le raccordement des composants électriques au moteur.

Dans le mode d'exécution décrit en référence à la figure 16, le procédé d'assemblage d'un véhicule selon l'invention comprend, suite à l'étape E22, trois étapes E23, E24, E25 de raccordement des composants électriques 2, 3, 4, 5, 6, 7 du pack électrique 10 aux autres composants 20, 30, 40, 50, 60, 70, 80, 90 du véhicule automobile 100. Les tuyaux et câblages mettant en œuvre les raccordements sont représentés dans les figures 17 à 19.

La troisième étape E23 est une étape de connexion de l'au moins un conduit de refroidissement hydraulique 801 aux premier et deuxième convertisseurs électriques 4, 5. Sur chacun des convertisseurs, le raccordement nécessite un premier embout pour l'entrée du fluide dans le convertisseur et un deuxième embout pour la sortie du fluide, le fluide circulant sous pression dans le convertisseur grâce à l'action d'une pompe située sur le circuit de refroidissement hydraulique comportant l'au moins un conduit de refroidissement hydraulique 801.

La quatrième étape E24 est une étape de fixation du conduit aéraulique 901 au boîtier 1 du pack électrique 10. Cette étape comprend le raccordement du conduit aéraulique 901 à une ouverture disposée sur la face latérale A du boîtier 1.

La cinquième étape E25 est une étape de raccordement de l'ensemble des composants électriques au câblage électrique 600.

L'étape E25 comprend une sous-étape de raccordement de la batterie 48 Volts 20 au bornier 6.

L'étape E25 comprend en outre une sous-étape de raccordement du bornier 6 aux divers équipements alimentés en 48 Volts ou en 12 Volts par l'intermédiaire du pack électrique 10. Notamment, l'étape E25 comprend donc le raccordement du bornier 6 au moteur électrique 50, aux équipements additionnels 60 et à la grille chauffante 70.

L'étape E25 comprend par ailleurs une sous-étape de raccordement du bornier 6 aux autres composants du pack électrique 10 pour leur alimentation, notamment un raccordement du bornier 6 au calculateur 3 et aux convertisseurs 4, 5.

L'étape E25 comprend en outre une sous-étape de raccordement de l'élément de sécurité 7 à la batterie 12 Volts 30, et aux divers circuits dépendant de l'éléments de sécurité 7. Autrement dit, cette sous-étape comprend un raccordement du deuxième circuit d'alimentation en 12 Volts reliant les convertisseurs 4, 5 et le calculateur moteur 2 à la batterie 12 Volts 30 via le boîtier d'interconnexion 35 et l'élément de sécurité 7.

D'autres modes d'exécution du procédé de montage d'un véhicule 100 selon l'invention sont envisageables. Par exemple, tout ou partie des étapes E23, E24, et E25 pourraient être effectuées avant tout ou partie des étapes de montage du pack électrique. De plus tout ou partie des sous-étapes de l'étape E25 de raccordement électrique pourraient être réparties avant, pendant ou après le montage du pack électrique.

Par exemple, afin de faciliter certains raccordements de l'étape E25, la sous-étape de raccordement de l'élément de sécurité 7 pourrait s'effectuer préférentiellement avant le montage de l'élément de sécurité 7 sur le boîtier 1.

Autrement dit, les différentes étapes et sous-étapes de raccordement ont été décrites sans présumer de l'ordre dans lequel elles s'effectuent.

Au total, les avantages du boîtier 1 selon l'invention sont multiples.

En premier lieu, le boîtier selon l'invention fournit une structure compacte pour un pack électrique regroupant notamment des composants nécessaires à l'utilisation d'une batterie 48V dans le véhicule 100.

Le pack électrique ainsi structuré par le boîtier est suffisamment compact pour se loger dans le compartiment moteur, dans un emplacement initialement alloué à une batterie 12 Volts.

De ce fait, grâce au boîtier selon l'invention, une batterie 48 Volts peut être aménagée dans un véhicule initialement conçu pour loger uniquement une batterie 12 Volts. L'aménagement de la batterie 48 Volts est ainsi possible en installant les batteries 12 Volts et 48 Volts sous la caisse du véhicule, et en installant le pack électrique dans l'emplacement initialement prévu pour la batterie 12 Volts.

De plus, le montage des composants électriques dans le véhicule est facilité par la simplicité de montage de ces éléments dans le boîtier, du fait de l'accessibilité des structures de fixations fournies par le boîtier. Les raccordements électriques, hydrauliques et aérauliques sont par ailleurs facilités par la répartition spatiale des connectiques de raccordement sur différentes faces du pack.

Le boîtier a également été conçu selon une logique d'accessibilité des composants du pack électrique, répondant à la fois à des critères d'ergonomie et de sécurité. Sur le plan de l'ergonomie, l'élément de sécurité de la batterie 12 Volts a été disposé de sorte à le rendre accessible par un usager. Sur le plan de la sécurité, le calculateur pour moteur a été disposé tout au fond du boîtier de sorte à compliquer et retarder son accès en cas d'acte malveillant sur le véhicule.

En outre, le pack électrique regroupe dans un espace réduit différents composants connectés les uns aux autres, ce qui permet de réduire la longueur, donc le coût, des câblages électriques entre ces composants.

Enfin, de par ses dimensions inférieures à l'encombrement d'une batterie 12 Volts, un tel boîtier est utilisable dans une large gamme de modèles de véhicules.

## Revendications

1. Boîtier (1) pour composants électriques d'un véhicule automobile (100) constituant un support pour au moins deux ou au moins trois composants électriques, notamment au moins deux ou au moins trois composants parmi :
- un premier convertisseur électrique de tension 48V-12V (4),
- un deuxième convertisseur électrique de tension 48V-12V (5),
- un calculateur pour moteur (2),
- un calculateur pour grille chauffante (3),
- un module de sécurité de batterie 12V (7), et
- un bornier électrique (6),
le boîtier comprenant :
- des éléments (E4, E5, A3, A4, A5, A6, C2, C3, C4, C5, 81, 82, 83, 84, 85, 86, AB, BC, CD, DA, 131, 132, 133, 134) de fixation des composants électriques au boîtier, et
- des éléments (E1, E2, E3) de fixation du boîtier à une structure de fixation (110) d'un véhicule automobile.

2. Boîtier (1) pour composants électriques d'un véhicule automobile (100) selon la revendication précédente, **caractérisé en ce que** ses dimensions lui permettent de s'insérer dans un espace prévu pour une batterie électrique 12V de type L3 et/ou **caractérisé en ce qu'**il est destiné à être implanté dans un compartiment moteur d'un véhicule automobile (100).

3. Boîtier (1) pour composants électriques d'un véhicule automobile selon l'une des revendications précédentes, **caractérisé en ce qu'**il comprend :
- une première partie (11) comprenant cinq faces (A, B, C, D, E) sensiblement planes constituant respectivement une base (E), de forme sensiblement rectangulaire, et quatre parois latérales (A, B, C, D) fixées perpendiculairement à la base (E), et
- un couvercle (12) s'emboitant sur la première partie (11), le couvercle présentant une face principale (F), notamment de forme sensiblement identique à la base (E), et,
- un logement (13) fixé sur le dessus de la face principale (F) du couvercle (12), le logement comprenant un socle (131, 132) et un couvercle (133).

4. Boîtier (1) pour composants électriques d'un véhicule automobile selon la revendication précédente, **caractérisé en ce qu'**une première paroi latérale (A, B, C, D) présente une ouverture destinée à un raccordement des composants électriques à une connectique électrique et **en ce qu'**une deuxième paroi latérale (A, B, C, D) présente une ouverture destinée à un raccordement des composants électriques à un circuit de refroidissement.

5. Boîtier (1) pour composants électriques d'un véhicule automobile selon l'une des revendications précédentes, **caractérisé en ce qu'**il comprend des aménagements permettant de disposer les composants électriques au moins sensiblement parallèlement les uns aux autres.

6. Boîtier (1) pour composants électriques d'un véhicule automobile selon la revendication précédente, **caractérisé en ce que** les aménagements sont agencés de sorte que les composants sont disposés :
- horizontalement, ou
- selon un angle aigu supérieur ou égal à 8° par rapport à l'horizontale, ou
- verticalement ou sensiblement verticalement.

7. Pack électrique (10) comprenant un boîtier (1) pour composants électriques selon l'une des revendications précédentes et au moins deux composants ou au moins trois parmi :
- un premier convertisseur électrique de tension 48 Volts-12 Volts (2),
- un deuxième convertisseur électrique de tension 48 Volts-12 Volts (3),
- un calculateur pour moteur (4),
- un calculateur pour grille chauffante (5),
- un élément de sécurité de batterie 12 Volts (7), et
- un bornier électrique (6).

8. Procédé d'assemblage d'un pack électrique (10) selon la revendication précédente, **caractérisé en ce qu'**il comprend les étapes suivantes :
- au moins une première étape de montage d'un premier composant électrique dans le boîtier, et
- au moins une deuxième étape de montage d'un deuxième composant électrique dans le boîtier,
par exemple :
- une première étape (E11) de pose du calculateur pour moteur (2) sur la base du boîtier (E),
- une deuxième étape (E12) de pose d'un premier convertisseur (4) au-dessus du calculateur pour moteur (2),
- une troisième étape (E13) de pose d'une plaque (8) au-dessus du premier convertisseur (4),
- une quatrième étape (E14) de pose du deuxième convertisseur (5) au-dessus de la plaque (8),
- une cinquième étape (E15) d'emboîtement du couvercle (12) du boîtier (1) sur la première partie (11) du boîtier (1),
- une sixième étape (E16) de pose du bornier électrique (6) dans le socle (131, 132) du logement (13) du boîtier,
- une septième étape (E17) d'emboîtement du couvercle (133) du logement (13) sur le socle (131, 132) du logement (13),
- une huitième étape (E18) de pose d'un calculateur pour grille chauffante (3) sur le couvercle (133) du logement (13), et
- une neuvième étape (E19) de fixation d'un élément de sécurité (7) sur la plaque (8),
les étapes de pose d'un composant comprenant au moins un assemblage du composant au boîtier (1).

9. Véhicule automobile (100) comprenant, notamment comprenant dans un compartiment moteur, un pack électrique (10) selon la revendication 7 ou obtenu selon la revendication 8.

10. Procédé d'assemblage d'un véhicule automobile (100), notamment d'un véhicule automobile (100) selon la revendication précédente, le véhicule comprenant au moins un conduit de refroidissement hydraulique (801), un conduit aéraulique (901), des câblages électriques (600) et une structure de fixation (110), **caractérisé en ce que** le procédé comprend :
- une première étape (E21) de fixation d'un boîtier (1) à la structure de fixation (110),
- une deuxième étape (E22) de mise en œuvre du procédé d'assemblage selon la revendication 7,
- une troisième étape (E23) de connexion de l'au moins un conduit de refroidissement hydraulique (801) au pack électrique (10), notamment à des convertisseurs électriques (4, 5),
- une quatrième étape (E24) de fixation du conduit aéraulique (901) au pack électrique (10),
- une cinquième étape (E25) de raccordement de l'ensemble des composants électriques au câblage électrique (600).
